(19) **Europäisches Patentamt / European Patent Office / Office européen des brevets**

(11) **EP 2 157 691 A1**

(12) **EUROPEAN PATENT APPLICATION**

(43) Date of publication:
**24.02.2010 Bulletin 2010/08**

(51) Int Cl.:
**H03D 7/00** (2006.01)

(21) Application number: **08162709.3**

(22) Date of filing: **20.08.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **ST-Ericsson Belgium NV**
**1930 Zaventem (BE)**

(72) Inventor: **Borremans, Marc**
**B-3050 Oud-Heverlee (BE)**

(74) Representative: **Bird, William Edward et al**
**Bird Goën & Co.**
**Klein Dalenstraat 42A**
**3020 Winksele (BE)**

(54) **Signal generation with cancelled harmonics**

(57)     A non-linear signal generation method and device are described where the phase of the nominally identical outputs from two non-linear devices are rotated by an angle θ with respect to each other. The output currents of both non-linear devices (such as amplifiers) are summed at the output. The phase rotation between the two output signals by the angle θ, results in harmonic signal components being cancelled. Which harmonic(s) is(are) cancelled depends upon the value of θ. This happens independent of the common-mode load applied.

Figure 1

**Description**

The present invention relates to non-linear devices such as amplifiers or mixers and methods of providing amplification or mixing of electrical signals, in particular to non-linear devices such as amplifiers or mixers and methods of providing amplification or mixing of electrical signals in which harmonics are cancelled in the output. The present invention also relates to methods, devices are systems for transmitting telecommunications signals and in particular wirelss signals and to coexistence in telecommunications systems and devices having non-linear devices such as amplifiers or mixers.

**Technical background**

The non-linearity of amplifiers used in telecommunication systems especially wireless telecommunication systems can cause a variety of problems. Non-linear power amplifiers generate side bands in the transmitted wireless signal that can interfere with other wireless transmission either within the same system or in other systems. These side bands or harmonics therefore compromise coexistence of telecommunications systems.

Within a telecommunications device harmonics can disturb a frequency synthesizer ( e.g. by coupling to a oscillator). This oscillator disturbance is called frequency "pulling". As the signal generated by a power amplifier is often modulated with traffic messages any coupled energy is also modulated thus resulting in the superimposition of different modulated signals. The pulling effect occurs when the RF transmitted signal frequency is close to the oscillator frequency.

Usually an oscillator used in a transceiver will operate at a higher frequency than a transmitted RF signal. The RF frequency is obtained by division of the oscillator signal. To avoid pulling, a transmitter topology where the oscillator operates at twice the channel frequency is often selected. For example, the oscillator (e.g. a VCO or DCO) is followed by a divider by 2. The frequency of the signal at the LO port of the mixer is "flo". Therefore, the fVCO = 2.flo. The frequency fRF is the frequency of the mixed product, i.e. of the baseband signal and the local oscillator signal: fRF = flo+fBB where fBB is the frequency of the baseband signal. Accordingly 2.fRF is the frequency of the second harmonic of the mixer output. The second harmonic of the RF signal is at f2RF= 2.flo+2.fbb which is close to the 2.flo oscillating frequency of the VCO/DCO. So the second harmonic is only separated from the oscillator frequency by 2.fbb, and can consequently make significant spurs in the oscillator spectrum when it couples through a parasitic (unwanted) path to the oscillator. Accordingly, coupling to the oscillator of this second harmonic (at twice fRF) component will create extra spurs in the oscillator spectrum at +/-2fbb from the carrier. Therefore also in this topology (with oscillator at 2fLO), 'pulling' spurs in the RF output spectrum can degrade the performance of the transmitter.

A known solution to improve coexistence is to use a filter to suppress the harmonics. A drawback of this known method is that although the filter suppresses the transmitted voltage at harmonic frequency, which is beneficial for coexistence, at the same time, it possibly generates large currents at harmonic frequency, causing magnetic coupling towards the inductor in the oscillator, being bad for the pulling effect.

Another known method is to provide a differential load so that the second order harmonics are common mode signals. A drawback of this method is that this is out of the control of the chip manufacturer. For example, a Z Ohm differential load could also be implemented by Z/2 Ohm to ground at each pin, generating currents in the common-mode signals. To avoid the flow of harmonic currents, the load specification should be specified at RF and at 2RF and as well as the common-mode as differential. The common-mode impedance should be as large as possible to avoid currents to flow. This implies special specifications on the 2RF impedance that will require complex and custom-designed components, which is not the preferred for low cost products. It will also be sensitive to board layout and spread on the components characteristics.

Making amplifiers non-linear has an effect on their efficiency. It would be much better to use non-linear amplifiers. However non-linear amplifiers generate significant energy in harmonics. To avoid these harmonics methods such as described above have to be used.

**Summary of the present invention**

An object of the present invention is to provide devices and methods (such as amplifiers or mixers and methods of providing amplification or mixing of electrical signals), in particular to devices and methods (such as amplifiers or mixers and methods of providing amplification or mixing of electrical signals) in which harmonics are cancelled in the output, as well as to provide methods, devices and systems for transmitting telecommunications signals and in particular wirelss signals providing a better coexistence in telecommunications systems.

The present invention provides a non-linear signal generation method and device (such as an amplifier or mixing method or device) where the phase of the nominally identical outputs from two non-linear devices are rotated by an angle θ with respect to each other. The output currents of both non-linear devices (such as amplifiers or mixers) are summed at the output. The phase rotation between the two output signals by the angle θ, results in Nth harmonic signal components being combined to a DC-component. Which harmonic(s) is (are) cancelled depends upon the value of $\theta$. This happens independent of the common-mode load applied. Consequently, no currents will flow to the load at N.fRF.

In a particular embodiment the angle $\theta$ is 90°. In this case the summation of the two amplifier signals can be represented by: Sin(wt)+cos(wt) = 1.414.cos(wt+p/4). This gives a signal with the same frequency, 1.414 times larger than the individual amplitude and 45 degrees phase shifted. This is a significant improvement in efficiency of a linear amplifier, for instance, especially at RF frequency, where no efficient feedback techniques can be used to linearise. The second harmonic signal components combine to a DC-component. Consequently, no currents will flow to the load at 2.fRF. This is advantageous when the oscillator frequency is at 2.flo (close to 2.fRF) as there is then no coupling between the harmonics of the power amplifiers and the oscillator signals.

In this way, a pulling robust transmitter is proposed being less sensitive to the load impedance and filter specifications. It also relaxes the specifications on the filtering for spurious emissions. Similarly, all (2m+1)N (e.g. 4N+2 (N:0, 1, 2, 3,... if m = 2)) harmonic components will be canceled.

Even with non-ideal component matching between the two transmitter paths, significant improvement can be achieved, e.g. a 10 % matching error gives still 20dB improvement.

Additionally, sharing some internal common signals like power supply, ground, bias can already locally cancel disturbances at (2m+1).N.fRF (e.g. (4N+2).fRF. This is for example valid for the common-mode 2RF currents in the power supply.

## Brief Description of the Drawings

Fig. 1 shows an arrangement of two non-linear amplifiers in a transmit path of a transmitter with I and Q inputs that are 90° out of phase with each other according to an embodiment of the present invention.

Fig. 2 shows an arrangement of a transmitter in accordance with an embodiment of the present which can be a stand-alone transmitter or part of a transceiver.

## Detailed description of the present invention

Preferred embodiments of the present invention will now be described in detail with reference to the annexed drawings. In the following description, a detailed description of known functions and configurations incorporated herein has been omitted for conciseness.

Although, the present invention will be described with respect to particular embodiments and with reference to certain drawings, the invention is not limited thereto but only by the claims. The drawings described are only schematic and are nonlimiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. Similarly, it is to be noticed that the term "connected", also used in the claims, should not be interpreted as being restricted to direct connections only, although "connected" includes a direct connection which may be advantageous. The term "coupling" should also be interpreted as not being limited to direct connections. Reference throughout this specification to "one embodiment" or "an embodiment" means that a particular feature, structure or characteristic described in connection with the embodiment is included in at least one embodiment of the present invention. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. Furthermore, while some embodiments described herein include some but not other features included in other embodiments, combinations of features of different embodiments are meant to be within the scope of the invention, and form different embodiments, as would be understood by those in the art. In the description provided herein, numerous specific details are set forth. However, it is understood that embodiments of the invention may be practised without these specific details. In other instances, well-known methods, structures and techniques have not been shown in detail in order not to obscure an understanding of this description.

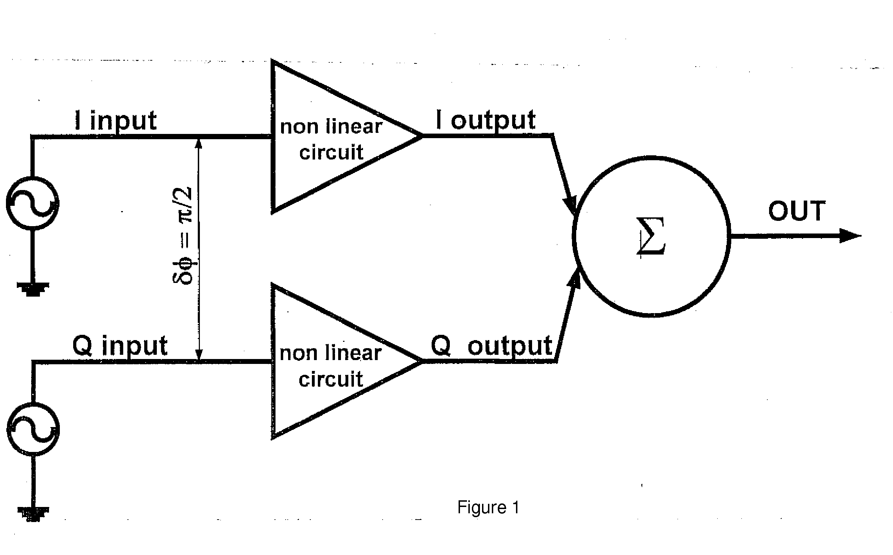

In embodiments of the present invention nominally identical signals from non-linear devices or circuits such as amplifiers are combined with a phase difference between the outputs as shown schematically in Fig. 1. In this figure two input signals such as signals to be transmitted from an RF transmitter are supplied to two non-linear amplifiers. The input signals are 90° out of phase. The outputs from the two amplifiers are added. In the output signal the second harmonic distortion is cancelled after amplification. The input signals can be modulated with an information signal, e.g. a voice or data signal, e.g. as found in a wireless phone, a modem, a base station, etc. In an alternative embodiment instead of summing after amplifiers, the summing can be done after other non-linear devices such as after duplicated mixers. In this way, for example, the second harmonic distortion of the mixer can be cancelled before amplification.

A non-linear system can be characterized by a transfer function. The output f(x) is written as a function of the input x

$$f(x)=DC_0 + a.x + b.x^2 + c.x^3+d.x^4 + e.x^5+f.x^6 + \ldots \qquad (eq.1)$$

With the application of a sine wave input signal, the transfer function can be rewritten based on following trigonometric identities:

$$\sin^2 x+ \cos^2 x =1 \qquad (eq.2)$$

$$\sin^2 x =1/2-1.2 \cos2x \qquad (eq.3)$$

$$\sin^3 x =3/4 \sin x -1/4 \sin3x \qquad (eq.4)$$

$$\sin^4 x =3/8 -1/2 \cos2x +1/8 \cos4x \qquad (eq.5)$$

$$\sin^5 x =5/8 \sin x -5/16 \sin 3x +1/16 \sin5x \qquad (eq.6)$$

$$\sin^6 x =5/16-15/32 \cos2x +3/16 \cos4x -1/32 \cos6x \qquad (eq.7)$$

These equations show the relation between the non-linearity and the spectral behavior. For example $\sin^5 x$ will give spurs at the fundamental frequency and at the 3rd and 5th harmonic.

Applying a sinewave I(t)=sinωt at the input a non linear system described by above equation results in:

$$f(I(t)) = DC_0 + 1/2b + 3/8d = 5/16f +$$

$$(a + 3/4c + 5/8e). \qquad \sin\omega t +$$

$$(-1/2b - 1/2d - 15/32f). \qquad \cos2\omega t +$$

$$(-1/4c - 5/16e). \qquad \sin3\omega t +$$

$$(1/8d + 3/16f). \qquad \cos4\omega t +$$

$$1/16e \qquad . \qquad \sin5x +$$

$$(-1/32f). \qquad \cos6x +$$

.... (eq.8)

Based on above equations, the sum of outputs at 90° phase difference, e.g. I and Q outputs in a transmitter is :

$$f(I(t)) + f(Q(t)) =$$

$$2.DC_0 + b + 3/4d + 5/8f +$$

$$(a + 3/4c + 5/8e). \qquad \sin\omega t +$$

$$(a + 3/4c + 5/8e). \qquad \cos\omega t +$$

$$\mathbf{0.} \qquad \mathbf{\cos2\omega t +}$$

$$(-1/4c - 5/16e). \qquad \sin3\omega t +$$

$$(+1/4c + 5/16e). \qquad \cos3\omega t +$$

$$(1/4d + 3/8f). \qquad \cos4\omega t +$$

$$1/16e \qquad . \qquad \sin5\omega t +$$

$$1/16e \qquad . \qquad \cos5\omega t +$$

$$\mathbf{0.} \qquad \mathbf{\cos6\omega t +}$$

.... (eq.9)

Based on the identities:

$$\mathrm{Sin}(x) + \cos(x) = \mathrm{sqrt}(2).\cos(x - \pi/4) \text{ and } \sin(x) - \cos(x) = \mathrm{sqrt}(2).\sin(x - \pi/4),$$

(eq.10)

this equation can also be written as :

$$f(I(t))+f(Q(t)) =$$

$$2.DC_0 +b+3/4d =5/8f+$$

$$sqrt(2).(a +3/4c+5/8e). \qquad cos(\omega t-\pi/4) +$$

$$\mathbf{0 .} \qquad \mathbf{cos2\omega t +}$$

$$sqrt(2).(-1/4c-5/16e) . \qquad sin(3\omega t-\pi/4)$$

$$(1/4d+3/8f) . \qquad cos4\omega t +$$

$$sqrt(2).1/16e . \qquad cos(5\omega t-\pi/4)+$$

$$\mathbf{0 .} \qquad \mathbf{cos6\omega t +}$$

$$…. \qquad\qquad\qquad\qquad (eq.11)$$

These equations demonstrate an aspect of the proposed invention, as the coefficient of at frequency of the second harmonic (and at any (4m+2)th harmonic) is 0. Accordingly in embodiments of the present invention where a dual transmitter path is provided and where the phase of the nominally identical outputs from two non-linear devices are rotated by an angle θ with respect to each other, the angle θ being (180 degrees)/N where N is an integer greater than 1, (N=2,3,4,...), the harmonics (2.m+1).N with m=0,1,2,3, are canceled. This finds particular advantageous use with a transmitter topology where an oscillator operates at an integer times the channel frequency, e.g. for θ = 90°, particular advantageous use is with a transmitter topology where the oscillator operates at two times the channel frequency.

For other values of θ, other harmonics can be cancelled such as :

θ = 30° cancels the 6th harmonics (N=6=>(12m+6)-th harmonics )
θ = 45° cancels the 4th harmonics (N=4=>(8m+4)-th harmonics)
θ = 60° cancels the 3rd harmonics (N=3=>(6m+3)-th harmonics )

The way such a phase difference is generated is not considered to be a limitation on the present invention. For example, the skilled person is aware or how to provide phase differences such as the above in a baseband signal in the digital domain.

The present invention find particular use in transmitters, e.g. of RF wireless transceivers or transmitters in which the outputs of two nominally identical amplifiers or mixers are summed to generate an output signal that has at least one harmonic cancelled.

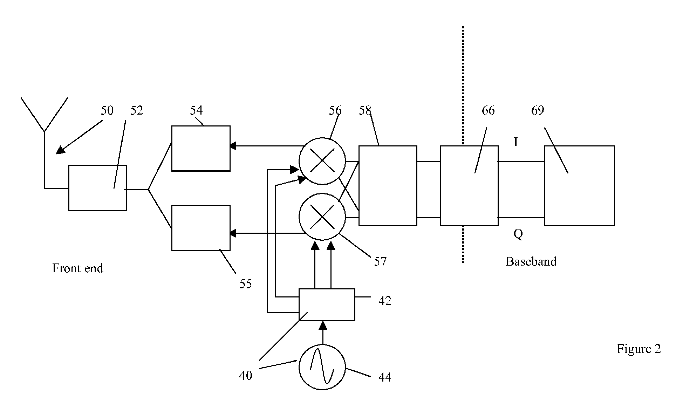

A transmitter according to an embodiment of the present invention is shown in Fig. 2. The transmitter can be a stand-alone transmitter or part of a transceiver. The radio front-end includes a radio upconversion device, e.g. comprising RF filters, a quadrature frequency synthesizer, and image-reject mixers to process input signals up to high frequencies.

For example, a radio signal to be transmitted is supplied to an antenna 50 and this radio signal is the result of processing by a radio front end upconversion device including a transmission band-pass filter 52, power amplifiers 54, 55, analog image-reject mixers 56, 57 and a low pass filter 58. In each image reject upconversion mixer 56, 57, both the baseband signal and the LO signal inputs are quadrature (I,Q) signals. The frequency synthesiser 40 can include an oscillator 44 at double the channel frequency followed by a divider by 2, (42). An advantage of this frequency synthesiser topology based on an oscillator 44 at double the channel frequency followed by a divider by 2, (42) is that this divider by 2 (42) provides the 4 quadrature LO signals to the mixers 56,57. The normal output of such image reject mixer 56, 57 is a single signal (optionally differential signal). The IQ inputs result in the intrinsic double-sideband modulation of the different internal mixer signal branches being recombined to a single sideband modulation.

On the baseband side the quadrature signal is generated in digital domain. The baseband source signal is processed in a unit 69 which can include a source coder, a modulator etc. Outputs of the unit 69 are the I and Q digital signals. In a DAC 66, the IQ signals received from unit 68 are converted to IQ analog signals. In accordance with this embodiment of the present invention two amplifiers are used 54, 55 each having an input that is 90° out of phase with the other. Hence the outputs of the amplifiers are also 90° out of phase with each other.

The mixer units 56, 57 each receive the IQ signals from filter 58 and mix with IQ signals from the quadrature frequency synthesiser 40 to upregulate the IQ signals. The upregulated IQ signals are supplied to nominally identical power amplifiers 54, 55. The outputs of the amplifiers 54, 55 are summed and fed to the antenna 50 via a filter 52.

As the phase difference between the IQ signals is 90° the second harmonic at least is cancelled in the summed outputs of amplifiers 54, 55.

Numerous other variations will also be apparent to one of ordinary skill in the art. It will therefore be appreciated by those of ordinary skill in the art that the invention can be embodied in other specific forms without departing from its spirit or essential character. The presently disclosed embodiments are therefore considered in all respects to be illustrative and not restrictive. The scope of the invention is indicated by the appended claims, and all changes which come within the meaning and range of equivalents thereof are intended to be embraced therein.

## Claims

1. A non-linear signal generation method comprising:

   providing two nominally identical signals from two non-linear devices, the relative phase of the two nominally identical signals being rotated by an angle ($\theta$) with respect to each other, the angle being (180 degrees)/N where N is an integer greater than 1; and
   summing the outputs of both non-linear devices resulting in a harmonic signal component of both outputs being cancelled in the summed signal.

2. The method of claim 1, wherein (2.m+1).Nth harmonics are cancelled where m is a positive integer.

3. The method of claim 1 or 2 wherein the non-linear devices are power amplifiers.

4. The method of claim 1 or 2 wherein the non-linear devices are mixers.

5. The method according to any previous claim, wherein the inputs to the non-linear devices are signals modulated with an information signal.

6. The method according to any previous claim, wherein the angle $\theta$ is 90° and at least a second harmonic is cancelled in the summed signal.

7. A telecommunications device, comprising:

   two non-linear signal emitting devices, the emitted signals being nominally identical but the relative phase of the two nominally identical signals being rotated by an angle $\theta$ with respect to each other, the angle being (180 degrees)/N where N is an integer greater than 1,
   an adder for summing the outputs of both non-linear devices resulting in a harmonic signal component of both outputs being cancelled in the summed signal.

8. The telecommunications device of claim 7 wherein (2.m+1).Nth harmonics are cancelled where m is a positive integer.

9. The telecommunications device of claim 7 or 8 wherein the non-linear devices are power amplifiers.

10. The telecommunications device of claim 7 or 8 wherein the non-linear devices are mixers.

11. The telecommunications device according to any of claim 7 to 10, wherein the inputs to the non-linear devices are signals modulated with an information signal.

12. The telecommunications device according to any of the claims 7 to 11, wherein the angle $\theta$ is 90° and at least a second harmonic is cancelled in the summed signal.

13. The telecommunications device according to any of the claims 7 to 12, wherein the telecommunications device is an RF wireless transmitter or transceiver.

14. The telecommunications device according to any of the claims 7 to 13, wherein the telecommunications device has a transmitter topology where an oscillator operates at twice the channel frequency.

15. The telecommunications device of claim 14, wherein the oscillator is a local oscillator or is part of a frequency synthesiser, for providing signals to be mixed with an information signal for upregulating the frequency of the information signal ready for wireless transmission.

Figure 1

50   52          54                    56   58          66      69

I

Front end

55

57                            Baseband

42

40          44

Figure 2

Europäisches
Patentamt

European
Patent Office

Office européen
des brevets

# EUROPEAN SEARCH REPORT

Application Number

EP 08 16 2709

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 882 191 B2 (KWOK S) 19 April 2005 (2005-04-19) * column 3, line 50 - column 7, line 63; figures 1-11 * ----- | 1-3,5-9, 11-15 | INV. H03D7/00 |
| X | US 6 766 158 B1 (MOLNAR) 20 July 2004 (2004-07-20) * column 1, line 21 - column 2, line 11 * * column 4, line 62 - column 6, line 41; figures 2,6,9 * ----- | 1,4,7,10 | |
| A | US 2003/007377 A1 (OTAKA) 9 January 2003 (2003-01-09) * paragraph [0030] - paragraph [0060]; figures 1-5 * ----- | 1-15 | |
| A | WO 2004/107562 A (THE UNIVERSITY OF NORTH CAROLINA) 9 December 2004 (2004-12-09) * page 10, line 15 - line 27 * * page 24, line 6 - page 28, line 15; figure 3 * ----- | 1-15 | |
| A | US 2004/145415 A1 (SUN B.) 29 July 2004 (2004-07-29) * paragraph [0020] - paragraph [0027]; figure 1 * ----- | 1-15 | TECHNICAL FIELDS SEARCHED (IPC) H03D H03C H03F |

The present search report has been drawn up for all claims

| Place of search | Date of completion of the search | Examiner |
|---|---|---|
| The Hague | 18 June 2009 | Butler, Nigel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 08 16 2709

This annex lists the patent family members relating to the patent documents cited in  the above-mentioned European search report.
The members are as contained in the European Patent Office EDP file on
The European Patent Office is in no way liable for these particulars which are merely given for the purpose of information.

18-06-2009

| Patent document cited in search report | | Publication date | Patent family member(s) | | Publication date |
|---|---|---|---|---|---|
| US 6882191 | B2 | 19-04-2005 | US | 2004257129 A1 | 23-12-2004 |
| US 6766158 | B1 | 20-07-2004 | NONE | | |
| US 2003007377 | A1 | 09-01-2003 | JP | 4004018 B2 | 07-11-2007 |
| | | | JP | 2003017944 A | 17-01-2003 |
| | | | KR | 20030003088 A | 09-01-2003 |
| WO 2004107562 | A | 09-12-2004 | AU | 2003231938 A1 | 21-01-2005 |
| US 2004145415 | A1 | 29-07-2004 | BR | PI0406900 A | 13-12-2005 |
| | | | KR | 20050094880 A | 28-09-2005 |
| | | | WO | 2004068700 A2 | 12-08-2004 |

EPO FORM P0459

For more details about this annex : see Official Journal of the European Patent Office, No. 12/82